# EUROPEAN PATENT APPLICATION

(11) **EP 2 562 548 A1**
(43) Date of publication of application: **27.02.2013**
(21) Application number: 11771721.5
(22) Date of filing: 08.04.2011
(51) Int. Cl.: G01R 11/24, G01R 22/00

(54) **DETECTION DEVICE AND DETECTION SYSTEM**

(30) Priority: 23.04.2010 JP 2010100409
(71) Applicant: Panasonic Corporation, Kadoma-shi Osaka 571-8501 (JP)
(72) Inventor: UNAGAMI, Yuji, Osaka 540-6207 (JP); NONAKA, Masao, Osaka 540-6207 (JP); FUTA, Yuichi, Osaka 540-6207 (JP); MATSUSHIMA, Hideki, Osaka 540-6207 (JP); MATSUZAKI, Natsume, Osaka 540-6207 (JP)
(74) Representative: Kügele, Bernhard
(86) International application number: PCT/JP2011/002084
(87) International publication number: WO 2011/132377

(57) **Abstract**

A detection apparatus (102) connected to a device in a residence and an electricity meter (100) indicating an amount of electric power consumed by the device in the residence, the detection apparatus (102) including: a reception unit (1021) which receives the amount of electric power from the electricity meter (100); a collection unit (1024) which collects usage status of the device; a device information holding unit (1027) which holds device information including the usage status of the device and electric power consumption of the device corresponding to the usage status; and a determination unit (1025) which determines whether or not the electricity meter (100) is tampered, by comparing an estimated electric power consumption amount with the amount of electric power received by the reception unit (1021), the estimated electric power consumption amount being estimated from the usage status of the device by using the device information, in which the determination unit (1025) determines that the electricity meter (100) is tampered, when a difference between the estimated electric power consumption amount and the amount of electric power received by the reception unit (1021) is equal to or more than a predetermined threshold.

## Description

### [Technical Field]

The present invention relates to detection apparatuses and detection systems, and particularly relates to a detection apparatus and a detection system which detect a fraudulently-tampered electricity meter.

### [Background Art]

The electric power is generally supplied to residences such as individual houses or apartments in an apartment building from a substation via an electricity meter (wattmeter) placed at each residence, and the supplied electric power is consumed by devices, etc. in the residence. In particular, a leading wire branched from a power line from the substation is connected to the electricity meter placed at each residence, and the electricity meter is connected with a distribution switchboard, and the distribution switchboard is connected with devices in the residence. The substation supplies the electric power to the devices in the residence via the leading wire, the electricity meter, and the distribution switchboard, and the supplied electric power is consumed by devices in the residence.

Most of the electricity meters are placed outside the residences, and the electric power consumed in each residence is calculated from the value indicated by the electricity meter. Then, an electric utility rate based on the calculated amount of electric power is charged for each individual house (each residence).

However, if the electricity meter is fraudulently altered, the electric power consumption amount cannot be measured accurately, and the electrical utility rate in accordance with the amount of electric power (charge for electric power consumption) would not be correctly charged. In addition, it is most likely that the electricity meter is fraudulently altered to steal electric power (fraudulent use of the electric power). Therefore, the electricity meter is generally sealed so that the alteration of the electricity meter can be detected. This enables detection of the alteration of the electricity meter when the seal of the electricity meter is fraudulently broken.

In addition, if a bypass line connecting the leading wire and the distribution switchboard is placed without interposing the electricity meter, the electricity meter cannot correctly measure the electric power consumption amount and the electric power is not correctly charged in accordance with the amount of electric power. For a technique to detect such stealing of the electric power, for example, a method described in Patent Literature 1 (PTL 1) is disclosed. The PTL 1 discloses a method of detecting alteration of the electricity meter by comparing the amount of electric power branched to a leading wire, detected by a current detecting device at the upstream of the leading wire and a current detecting device at the downstream of the leading wire, with the amount of electric power measured by the electricity meter, the leading wire leading to each individual house (each residence) that is a consumer of the electric power on a power line from the substation.

### [Citation List]

### [Patent Literature]

[PTL 1] Japanese Patent No. 4239677

### [Non Patent Literature]

[NPL 1] Tatsuaki OKAMOTO and Hirosuke YAMAMOTO, "Gendai Ango", Sangyo-Tosho Publishing Co. Ltd. (1997)

### [Summary of Invention]

### [Technical Problem]

However, the above-mentioned method has such a problem that a fraudulent use of the electric power (stealing electric power) cannot be sufficiently detected.

Specifically, a digital electricity meter (without a disk) indicating an electric power consumption amount by using software is becoming common, and a method of detecting alteration of an electricity meter by enclosing the electricity meter cannot detect the alteration of the software inside the digital electricity meter. In other words, the fraudulent use of the electrical power (stealing electrical power) may be possible without breaking the seal of the electricity meter, by tampering the internal software in the digital electricity meter.

Moreover, the technique disclosed in PTL 1 detects the fraudulent use of the electrical power (stealing electric power) by placing the current detecting devices at the upstream and downstream of the leading wire. However, it is a problem that the fraudulent use of the electric power (stealing electric power) cannot be detected if a bypass line connecting the power line and the distribution switchboard is placed in such a manner that the current detecting devices are not interposed.

The present invention is conceived in view of the above situations, and it is an object of the present invention to provide a detection apparatus and a detection system which detect the fraudulent use of the electric power.

### [Solution to Problem]

In order to achieve the aforementioned object, a detection apparatus according to an embodiment of the present invention is a detection apparatus connected to a device in a residence and an electricity meter indicating an amount of electric power consumed by the device in the residence, the detection apparatus including: a reception unit which receives the amount of electric power from the electricity meter; a collection unit which collects usage status of the device; a device information holding unit which holds device information including the usage status of the device and electric power consumption of the device corresponding to the usage status; and a determination unit which determines whether or not the electricity meter is tampered, by comparing an estimated electric power consumption amount with the amount of electric power received by the reception unit, the estimated electric power consumption amount being estimated from the usage status of the device by using the device information, in which the determination unit determines that the electricity meter is tampered, when a difference between the estimated electric power consumption amount and the amount of electric power received by the reception unit is equal to or more than a predetermined threshold.

### [Advantageous Effects of Invention]

According to the present invention, the detection apparatus and the detection system which detect fraudulent use of the electric power can be achieved.

Specifically, whether or not the electricity meter is tampered can be verified as follows. An estimated electric power consumption amount which is estimated from the usage status of the device is calculated. Subsequently, the estimated electric power consumption is compared with the amount of electric power received from the electricity meter. Then, it is determined whether or not a difference is equal to or more than a predetermined amount. This process makes it possible to avoid fraudulent use of the electric power due to tampering of the electricity meter.

### [Brief Description of Drawings]

[Fig. 1] FIG. 1 is a diagram showing a whole configuration of an electric power supplying system according to Embodiment 1 of the present invention.
[Fig. 2] FIG. 2 is a diagram showing a configuration of a residence 10 according to Embodiment 1 of the present invention.
[Fig. 3] FIG. 3 is a block diagram showing a detailed configuration of a detection apparatus 102 according to Embodiment 1 of the present invention.
[Fig 4A] FIG. 4A is a diagram showing an example of the device information held by a device information holding unit according to Embodiment 1 of the present invention.
[Fig 4B] FIG. 4B is a diagram showing an example of the device information held by the device information holding unit according to Embodiment 1 of the present invention.
[Fig. 5] FIG. 5 is a block diagram showing a detailed configuration of a management apparatus 20 according to Embodiment 1 of the present invention.
[Fig. 6] FIG. 6 is a flowchart for describing a general process of a detection system according to Embodiment 1 of the present invention.
[Fig. 7] FIG. 7 is a sequence diagram for describing an initial registration process of the detection system according to Embodiment 1 of the present invention.
[Fig. 8] FIG. 8 is a sequence diagram for describing the initial registration process of the detection system according to Embodiment 1 of the present invention.
[Fig. 9] FIG. 9 is a sequence diagram for describing a detection process of the detection system according to Embodiment 1 of the present invention.
[Fig. 10] FIG. 10 is a sequence diagram for describing the detection process of the detection system according to Embodiment 1 of the present invention.
[Fig. 11] FIG. 11 is a diagram showing another configuration of the residence 10 according to Embodiment 1 of the present invention.
[Fig. 12] FIG. 12 is a diagram showing another configuration of the residence 10 according to Embodiment 1 of the present invention.
[Fig. 13] FIG. 13 is a block diagram showing a detailed configuration of a detection apparatus 402 according to Embodiment 2 of the present invention.
[Fig. 14] FIG. 14 is a block diagram showing a detailed configuration of a management apparatus 40 according to Embodiment 2 of the present invention.
[Fig. 15] FIG. 15 is a flowchart for describing a general process of a detection system according to Embodiment 2 of the present invention.
[Fig. 16] FIG. 16 is a sequence diagram for describing the detection process of the detection system according to Embodiment 2 of the present invention.
[Fig. 17] FIG. 17 is a sequence diagram for describing the detection process of the detection system according to Embodiment 2 of the present invention.
[Fig. 18] FIG. 18 is a sequence diagram for explaining a process of adding the device information according to a modification of the present invention.

### [Description of Embodiments]

A detection apparatus according to a first aspect of the present invention is a detection apparatus connected to a device in a residence and an electricity meter indicating an amount of electric power consumed by the device in the residence, the detection apparatus including: a reception unit which receives the amount of electric power from the electricity meter; a collection unit which collects usage status of the device; a device information holding unit which holds device information including the usage status of the device and electric power consumption of the device corresponding to the usage status; and a determination unit which determines whether or not the electricity meter is tampered, by comparing an estimated electric power consumption amount with the amount of electric power received by the reception unit, the estimated electric power consumption amount being estimated from the usage status of the device by using the device information, in which the determination unit determines that the electricity meter is tampered, when a difference between the estimated electric power consumption amount and the amount of electric power received by the reception unit is equal to or more than a predetermined threshold.

This configuration allows determination of whether or not the electricity meter is tampered by calculating the estimated electric power consumption amount which is estimated from the usage status of the device, comparing the estimated electric power consumption amount with the amount of electric power received from the electricity meter, and verifying the difference. Accordingly, the detection apparatus which detects fraudulent use of the electric power can be achieved. The use of the detection apparatus prevents the fraudulent use of the electric power due to tampering of the electricity meter.

A detection apparatus according to a second aspect of the present invention, in which the reception unit receives, from the electricity meter, an amount of electric power when the usage status of the device is changed, and the determination unit determines whether or not the electricity meter is tampered, by comparing an estimated electric power consumption amount with the amount of electric power received by the reception unit, the estimated electric power consumption amount being estimated from the changed usage status of the device by using the device information.

This configuration makes it possible to verify the difference with the variation of the electric power consumption by detecting tampering of the electricity meter according to the change of the usage status of the device. This enables improvement of the accuracy of the detection of tampering of the electricity meter.

Moreover, a detection apparatus according to a third aspect of the present invention further includes a notification unit which notifies a user of information indicating that the electricity meter is determined to be tampered, when the determination unit determines that the electricity meter is tampered.

Moreover, a detection apparatus according to a fourth aspect of the present invention further includes an update unit which updates the device information, in which the collection unit further collects usage history information including previous electric power consumption amounts for usage status of the device, and the update unit updates the device information by reflecting the usage history information in the usage status of the device and the electric power consumption of the device corresponding to the usage status.

This configuration allows update of the electric power consumption amount estimated from the history of the electric power consumption amount. This enables improvement of the accuracy of the estimated electric power consumption amount and improvement of the accuracy of the detection of tampering of the electricity meter.

A detection apparatus according to a fifth aspect of the present invention further includes an update unit which updates the device information, in which the collection unit further collects device setting information indicating a load of the device in use and a setting of the device in use, and the update unit updates the device information by reflecting the device setting information in the usage status of the device and the electric power consumption of the device corresponding to the usage status.

This configuration allows update of the estimated electric power consumption amount which is estimated from the load of the device in use and the device setting information, i.e., the settings set for the device. This enables improvement of the accuracy of the estimated electric power consumption amount and improvement of the accuracy of the detection of tampering of the electricity meter.

In a detection apparatus according to a sixth aspect of the present invention, the usage status includes at least a state where a power of the device is ON and a state where the power of the device is OFF.

A detection apparatus according to a seventh aspect of the present invention further includes a device information verification unit which verifies whether or not the device information held by the device information holding unit is tampered.

This configuration allows detection of tampering and correct calculation of the estimated electric power consumption amount which is estimated from the device information and the usage status of the device, even when the device information is tampered. This ensures detection of the tampering of the electricity meter.

A detection system according to an eighth aspect of the present invention is a detection system including a device in a residence, an electricity meter indicating an amount of electric power consumed by the device in the residence, and a detection apparatus connected to the electricity meter and the device in the residence, in which the detection apparatus includes: a reception unit which receives the amount of electric power from the electricity meter; a collection unit which collects usage status of the device; a device information holding unit which holds device information including the usage status of the device and electric power consumption of the device corresponding to the usage status; and a determination unit which determines whether or not the electricity meter is tampered, by comparing an estimated electric power consumption amount with the amount of electric power received by the reception unit, the estimated electric power consumption amount being estimated from the usage status of the device by using the device information, in which the determination unit determines that the electricity meter is tampered, when a difference between the estimated electric power consumption amount and the amount of electric power received by the reception unit is equal to or more than a predetermined threshold.

A detection system according to a ninth aspect of the present invention further includes a management apparatus connected to the detection apparatus, in which the management apparatus includes a verification unit verifies whether or not the detection apparatus is tampered.

A detection apparatus according to a tenth aspect of the present invention is placed outside the residence.

A detection method according to an eleventh aspect of the present invention is a detection method used for a detection apparatus connected to a device in a residence and an electricity meter consumed by the device in the residence, the method including: receiving an amount of electric power from the electricity meter; holding device information including usage status of the device and electric power consumption of the device corresponding to the usage status; and determining whether or not the electricity meter is tampered, by comparing an estimated electric power consumption amount with the amount of electric power received by the reception unit, the estimated electric power consumption amount being estimated from the usage status of the device by using the device information, in which in the determining, the electricity meter is determined to be tampered, when a difference between the estimated electric power consumption amount and the amount of electric power received by the reception unit is equal to or more than a predetermined threshold.

A detection program according to a twelfth aspect of the present invention is a detection program used for a detection apparatus connected to a device in a residence and an electricity meter consumed by the device in the residence, the program including: receiving an amount of electric power from the electricity meter; holding device information including usage status of the device and electric power consumption of the device corresponding to the usage status; and determining whether or not the electricity meter is tampered, by comparing an estimated electric power consumption amount with the amount of electric power received by the reception unit, the estimated electric power consumption amount being estimated from the usage status of the device by using the device information, in which in the determining, the electricity meter is determined to be tampered, when a difference between the estimated electric power consumption amount and the amount of electric power received by the reception unit is equal to or more than a predetermined threshold.

An integrated circuit according to a thirteenth aspect of the present invention is an integrated circuit connected to a device in a residence and an electricity meter indicating an amount of electric power consumed by the device in the residence, the detection apparatus including: a reception unit which receives the amount of electric power from the electricity meter; a collection unit which collects usage status of the device; a device information holding unit which holds device information including the usage status of the device and electric power consumption of the device corresponding to the usage status; and a determination unit which determines whether or not the electricity meter is tampered, by comparing an estimated electric power consumption amount with the amount of electric power received by the reception unit, the estimated electric power consumption amount being estimated from the usage status of the device by using the device information, in which the determination unit determines that the electricity meter is tampered, when a difference between the estimated electric power consumption amount and the amount of electric power received by the reception unit is equal to or more than a predetermined threshold.

Hereinafter, embodiments according to the present invention are described with reference to the drawings.

### (Embodiment 1)

### 1. System configuration

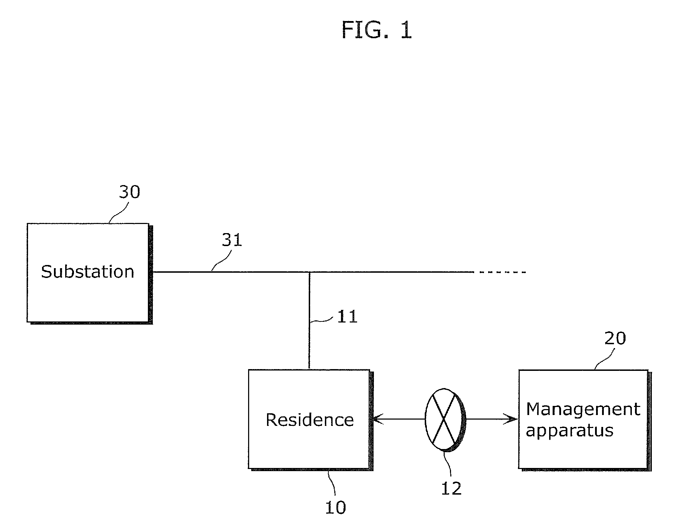

FIG. 1 is a configuration diagram of a whole electric power supplying system according to Embodiment 1 of the present invention.

The electric power supplying system as shown in FIG. 1 includes a residence 10, a leading wire 11, a management apparatus 20, a substation 30, and a power line 31.

The substation 30 is connected to the power line 31 and supplies an electric power to the residence 10 via the leading wire 11.

In addition, the residence 10 is connected to the management apparatus 20 via a network 12.

### 2. Configuration of residence 10

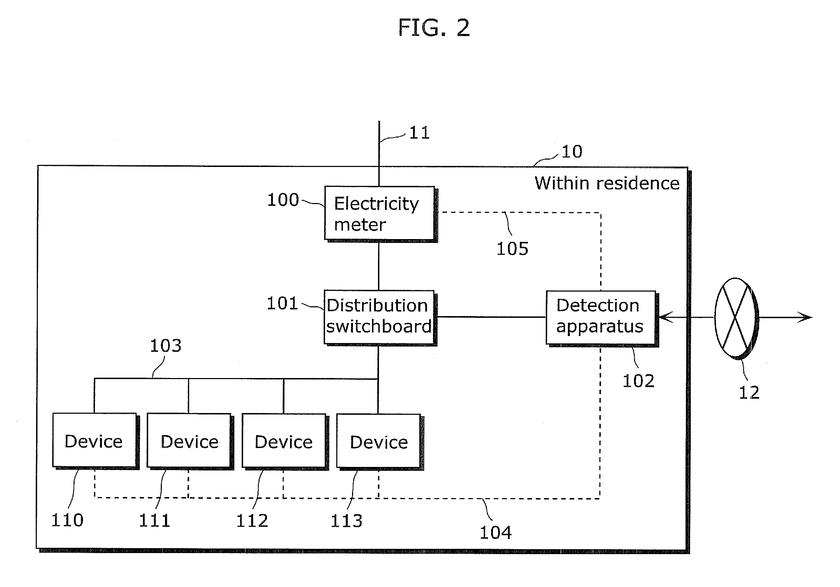

FIG. 2 is a diagram showing a configuration of the residence 10 according to Embodiment 1 of the present invention. As shown in FIG. 2, the residence 10 includes an electricity meter 100, a distribution switchboard 101, a detection apparatus 102, and devices 110 to 113.

The electricity meter 100 is connected to the leading wire 11, and integrates (measures) the electric power consumed in the residence 10. The electricity meter 100 has a display for externally displaying the integrated electric power consumption amount. Then, the electric utility rate is charged to the residence 10 based on the amount of electric power displayed on the display. Note that the electricity meter 100 may transmit the amount of electric power displayed on the display to the management apparatus 20 via a network 105. In addition, the electricity meter 100 may transmit the amount of electric power displayed on the display to a power company via the management apparatus 20 or the network 12.

The distribution switchboard 101 supplies the electric power transmitted (supplied) from the leading wire 11 via the electricity meter 100 to each device (devices 110 to 113) through interior wiring 103.

The detection apparatus 102 is connected to the devices 110 to 113 in the residence 10 and to the electricity meter 100 indicating the electric power consumption amount consumed by the devices, and detects whether or not the electricity meter 100 is tampered. Specifically, the detection apparatus 102 is connected to the electricity meter 100 and to the devices 110 to 113 via the network 104, and collects information of electric power consumption amounts and usage status of the devices. Then, the detection apparatus 102 determines whether or not the electricity meter 100 is tampered based on the usage status of the devices 110 to 113 and the electric power consumption amount transmitted from the electricity meter 100.

Here, the usage status refers to, for example, a state in which the power of a device is turned ON and the device is being used (in use), a state in which the device is unplugged and the power of the device is completely OFF (stop), or a state in which the main power of the device is OFF (standby). Note that a detailed configuration of the detection apparatus 102 will be described later, and thus the description of the detection apparatus 102 is omitted here.

The devices 110 to 113 are devices used in the residence 10. For example, they are home electric appliances such as a TV, an air conditioner, and a lighting apparatus. The devices 110 to 113 are connected to the detection apparatus 102 via the network 104, and transmit the usage status to the detection apparatus 102.

The residence 10 is configured as described above.

Next, a detailed configuration of the detection apparatus 102 is described.

### 2.1. Detailed configuration of detection apparatus 102

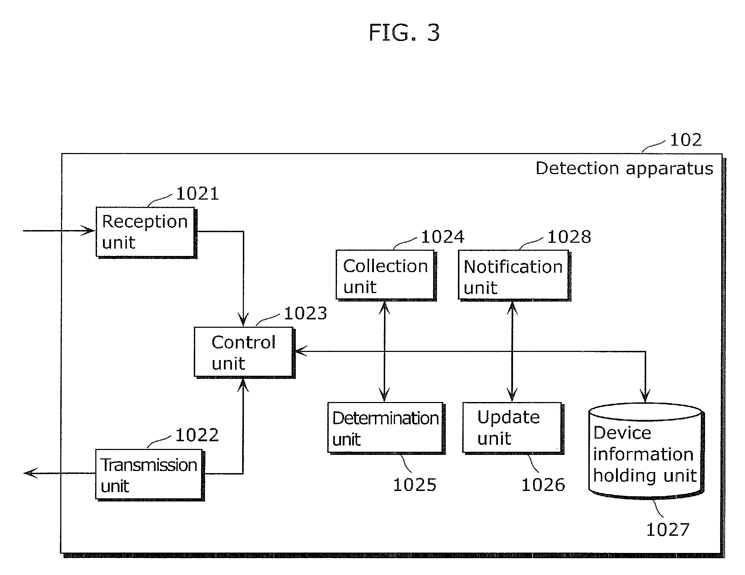

FIG. 3 is a block diagram showing the detailed configuration of the detection apparatus 102 according to Embodiment 1 of the present invention. The detection apparatus 102 shown in FIG. 3 includes: a reception unit 1021, a transmission unit 1022, a control unit 1023, a collection unit 1024, a determination unit 1025, an update unit 1026, a device information holding unit 1027, and a notification unit 1028.

The reception unit 1021 receives an amount of electric power at least from the electricity meter 100. Specifically, the reception unit 1021 receives, for example, an electric power consumption amount transmitted from the electricity meter 100; usage status transmitted from the devices 110 to 113; and power consumption of the devices 110 to 113, which corresponds to the usage status transmitted from the management apparatus 20. Moreover, when any one of the usage status of the devices 110 to 113 is changed, the reception unit 1021 receives the amount of electric power from the electricity meter 100.

The transmission unit 1022 transmits, to the devices 110 to 113, various requests such as a request for collecting the device information.

The control unit 1023 controls the collection unit 1024, the determination unit 1025, the update unit 1026, and the notification unit 1028. Moreover, the control unit 1023 detects whether or not the electricity meter 100 is tampered by controlling the collection unit 1024, the determination unit 1025, and the update unit 1026.

The collection unit 1024 collects the usage status of the devices 110 to 113. Specifically, the collection unit 1024 collects at least device information and/or usage status of the devices 110 to 113.

Note that the collection unit 1024 does not only collect the device information and/or the usage status of the devices 110 to 113, but may also collect device setting information indicating loads of the devices 110 to 113 in use and settings of the devices 110 to 113 in use. In addition, the collection unit 1024 may further collect usage history information including the previous electric power consumption amounts with respect to the usage status of the devices 110 to 113.

The device information holding unit 1027 holds device information including the usage status of the devices 110 to 113 and the power consumption of the devices 110 to 113, which corresponds to the usage status. Specifically, the device information holding unit 1027 holds a device information list 10271 or a device information list 10272 as the device information.

Here, the device information list 10271 or the device information list 10272 is described.

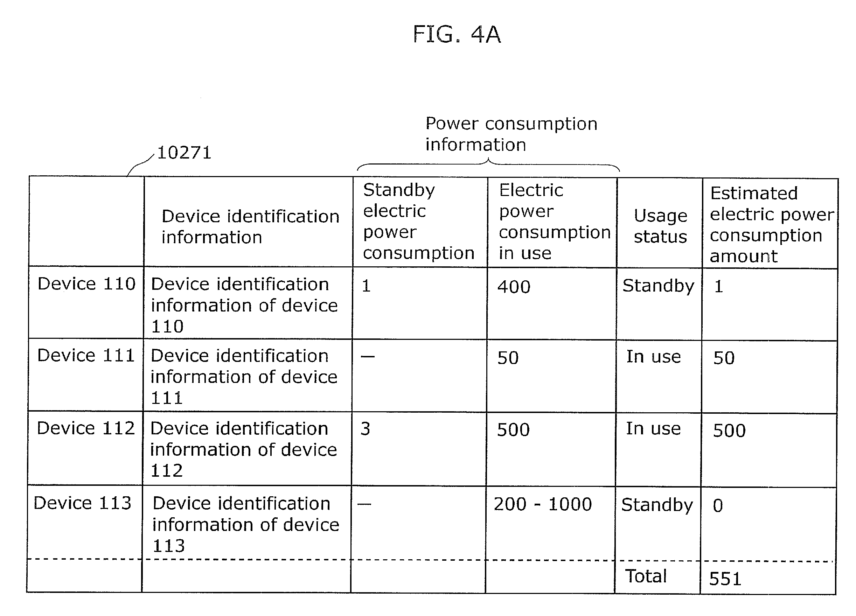

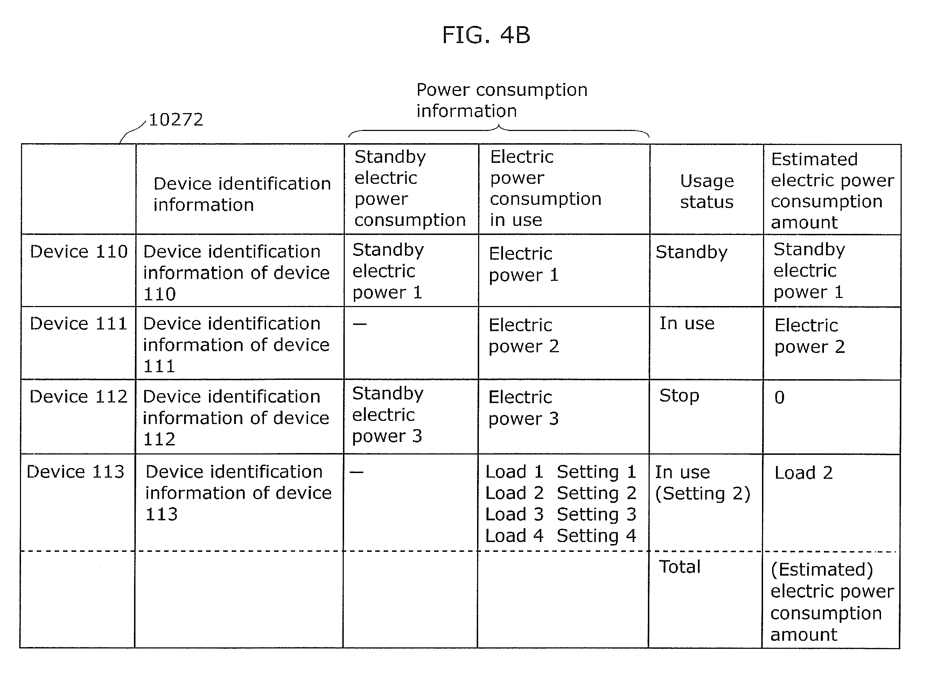

FIGS. 4A and 4B are diagrams showing examples of the device information held by the device information holding unit according to Embodiment 1 of the present invention.

The device information includes usage status of the devices and electric power consumption (electric power consumption information) corresponding to the usage status of the devices 110 to 113. A typical example of the device information is the device information list 10271 shown in FIG. 4A or the device information list 10272 shown in FIG. 4B. The device information is held in the device information holding unit 1027.

The device information list 10271 shown in FIG. 4A includes device identification information of each device (devices 110 to 113), electric power consumption information, standby electric power consumption, electric power consumption in use, usage status, and an estimated electric power consumption amount.

The electric power consumption information includes electric power consumption during standby (standby electric power consumption) and electric power consumption during use (electric power consumption in use) of the devices 110 to 113. Moreover, the estimated electric power consumption amount is the electric power consumption amount estimated from the electric power consumption information of the devices 110 to 113, the information corresponding to the usage status of the devices 110 to 113. For example, when the devices 110 to 113 are not in use, the estimated electric power consumption amount is the electric power consumption estimated from the standby power consumption. When the devices 110 to 113 are in use, the estimated electric power consumption amount is the electric power consumption estimated from the power consumption in use.

As is clear from FIG. 4A, when the detection apparatus 102 correctly collects the usage status and the power consumption information of the devices 110 to 113, the total of the estimated power consumption amounts of all of the devices in the residence 10 corresponds to the amount of electric power used in the residence 10. Of course, as described above, the power consumption of the devices 110 to 114 in use varies depending on the usage environment. In addition, there is a difference between the power consumption in the specification in a catalog and the actual power consumption in use due to usage environment and aged deterioration. In other words, it is preferable to consider the electric power consumption in the specifications in the catalog and the actual electric power consumption are the same if the increase in the electric power consumption due to the usage environment is within a predetermined range (equal to or less than a predetermined threshold).

For example, if the device is a refrigerator, the electric power consumption varies depending on the temperature setting in each compartment of the refrigerator, ambient temperature and humidity, and frequency of opening and closing the doors of the refrigerator. This is because when the temperature in a compartment rises due to opening and closing the door, an electrical load is imposed on the refrigerator to return the temperature in the compartment to a preset temperature. Therefore, in such a case where several percentages of increase in the power consumption amount is expected, a range including the expected amount of increase may be set as the estimated power consumption. Then, the range including the increase in the electric power consumption due to the usage environment may be received from the management apparatus 20.

Note that the usage status and the power consumption in use are not limited to those shown in the device information list 10271. One example of the usage status and the power consumption in use is the device information list 10272 shown in FIG. 4B.

The differences between the device information list 10272 shown in FIG. 4B and the device information list 10271 are that a state of being stopped is included in the usage status, and the device 113 is included, whose electric power consumption in use varies even during the device is being used due to settings, etc. set for the device.

There is a device whose electric power consumption varies depending on time and settings set for the device (referring to the device 113 here), for example, a device such as an air conditioner whose driving status changes between air-cooling and heating, and a device such as a vacuum cleaner whose power consumption in use varies depending on a load. Moreover, the power consumption in use varies because the loads vary depending on the settings set for the devices. For example, the load in the air conditioner varies due to the settings of the preset temperature and humidity, and the load in the vacuum cleaner varies depending on the setting of the strength of suction.

The device information list 10272 holds a setting to be set in the above-mentioned device (settings 1 to 4 in FIG. 4B) and the power consumption in use corresponding to the loads (loads 1 to 4) due to the settings.

The determination unit 1025 determines whether or not the electricity meter 100 is tampered by comparing i) the electric power consumption amount estimated using the device information (device information list 10271 or device information list 10272) based on the usage status of the devices 110 to 113 and ii) the amount of electric power received by the reception unit 1021. More specifically, the determination unit 1025 calculates the estimated power consumption amount which is estimated from the current usage status of the devices 110 to 113 by using the device information list 10271 or the device information list 10272 which are held in the device information holding unit 1027, and compares the estimated power consumption amount with the electric power consumption amount received from the electricity meter 100 in the reception unit 1021.

Moreover, when the usage status of at least one of the devices 110 to 113 changes, the determination unit 1025 determines whether or not the electricity meter 100 is tampered by comparing the electric power estimated by using the device information (the device information list 10271 or the device information list 10272) which is changed based on the varied usage status, and the amount of electric power after change of the usage status, which is received by the reception unit 1021.

The determination unit 1025 determines the electricity meter 100 is tampered when a difference between the estimated electric power consumption amount and the amount of electric power received in the reception unit 1021 is equal to or more than the predetermined threshold. Then, when the determination unit 1025 determines that the electricity meter 100 is tampered, the determination unit 1025 notifies the management apparatus 20 of the information indicating that the electricity meter 100 is tampered. Note that the determination unit 1025 may also notify the notification unit 1028 of the same information. In this case, the notification unit 1028 notifies a user of the information.

The notification unit 1028 notifies the user of information indicating that the electricity meter 100 is tampered, when the determination unit 1025 determines that the electricity meter 100 is tampered. Typically, the notification unit 1028 notifies the user of the information indicating that the electricity meter 100 is tampered, when the notification unit 1028 is notified that the electricity meter 100 is determined to be tampered by the determination unit 1025. Note that the notification unit 1028 may obtain the determination result of the determination unit 1025. In this case, the notification unit 1028 may notify the user of the tampering of the electricity meter 100, when the notification unit 1028 receives the determination result indicating that the determination unit 1025 determines that the electricity meter 100 is tampered.

The update unit 1026 updates the device information. Specifically, the update unit 1026 updates the device information (device information list 10271 or device information list 10272) held in the device information holding unit 1027 when the usage status of the device, the estimated electric power consumption amount, etc. are changed.

For example, when the collection unit 1024 collects usage history information including the previous electric power consumption amounts with respect to usage status of the devices 110 to 113, the update unit 1026 updates the device information (device information list 10271 or device information list 10272) by reflecting the usage history information in usage status of the devices 110 to 113 and electric power consumption of the devices 110 to 113 corresponding to the usage status, the usage status and the electric power consumption included in the device information. With this configuration, the detection apparatus 102 can update the electric power consumption amount estimated from the history of the previous electric power consumption of the devices 110 to 113. Therefore, the accuracy of the estimated electric power consumption amount and the accuracy of detecting tampering of the electricity meter can be improved.

Moreover, for example, when the collection unit 1024 collects loads of the devices 110 to 113 in use and device setting information indicating settings of the devices 110 to 113 in use, the update unit 1026 updates device information (device information list 10271 or device information list 10272) by reflecting the device setting information in usage status of the devices 110 to 113 and electric power consumption of the devices 110 to 113 corresponding to the usage status, the usage status and the electric power consumption included in the device information. With this configuration, the detection apparatus 102 can update the electric power consumption amount estimated from the loads of the devices 110 to 113 in use and the device setting information, i.e., settings set for the devices 110 to 113. Therefore, the accuracy of the estimated electric power consumption amount and the accuracy of detecting tampering of the electricity meter can be improved.

As described above, the detection apparatus 102 is configured.

Next, a detailed configuration of the management apparatus 20 is described.

### 3. Configuration of management apparatus 20

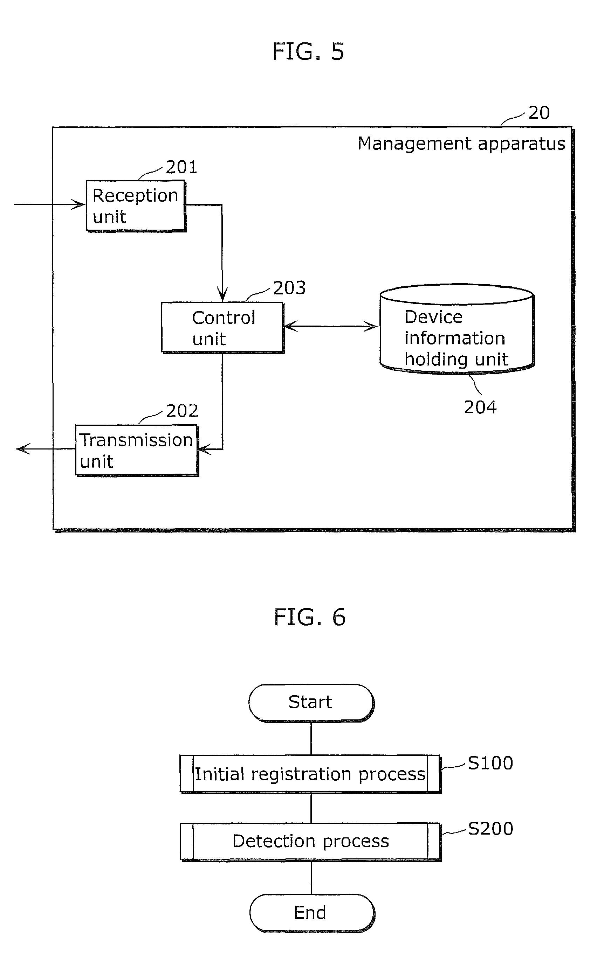

FIG. 5 is a block diagram showing a detailed configuration of the management apparatus 20 according to Embodiment 1 of the present invention. The management apparatus 20 shown in FIG. 5 includes a reception unit 201, a transmission unit 202, a control unit 203, and a device information holding unit 204.

The reception unit 201 receives notification and various requests and so on, from the detection apparatus 102.

The transmission unit 202 transmits device information about the devices 110 to 113 to the detection apparatus 102. The device information includes information about electric power consumption of the devices 110 to 113. In addition, the electric power consumption information includes electric power consumption of the devices 110 to 113 corresponding to the usage status of the devices 110 to 113. In addition, the power consumption of the devices 110 to 113 includes standby electric power (electric power consumption when the power is OFF) and electric power consumption of on-state (electric power consumption when the power is ON).

The control unit 203 obtains the electric power consumption information of devices from the device information holding unit 204 based on a request from the detection apparatus 102, and transmits electric power consumption information of the devices to the detection apparatus 102 via the transmission unit 202.

The device information holding unit 204 holds the device information about the devices 110 to 113.

The management apparatus 20 is configured as described above.

Next, a detection system including the devices 110 to 113, the detection apparatus 102, and the management apparatus 20 is described. A configuration of each of the elements in the detection system is omitted because it has been already described above. The following describes an operation of the detection system.

### 4. Summary of operation of detection system

First, a general process of the detection system is described.

FIG. 6 is a flowchart for describing the general process of the detection system according to Embodiment 1 of the present invention. As shown in FIG. 6, there are two processes described below as the general process of the detection system.

The first process is a process of registering information (initial registration process) of the devices in the residence 10 after the detection apparatus 102 is placed in the residence 10. The second process is a process of detecting (detection process) whether or not the electricity meter 100 is tampered.

Specifically, after the detection apparatus 102 is placed, the detection system registers, for example, device information of the devices 110 to 113 in the residence 10 to the device information holding unit 1027 in the detection apparatus 102 (S100).

Next, after the device information is registered, the detection apparatus 102 calculates an estimated electric power consumption amount which is estimated from the usage status of the devices in the residence 10, and compares the estimated electric power consumption amount with the amount of electric power indicated by the electricity meter 100 to thereby perform a detection process of detecting whether or not the electricity meter 100 is tampered (S200).

Next, details of the above-mentioned two processes are described in turn.

### 5. Operation of initial registration process

First, details of the initial registration process (S100) are described.

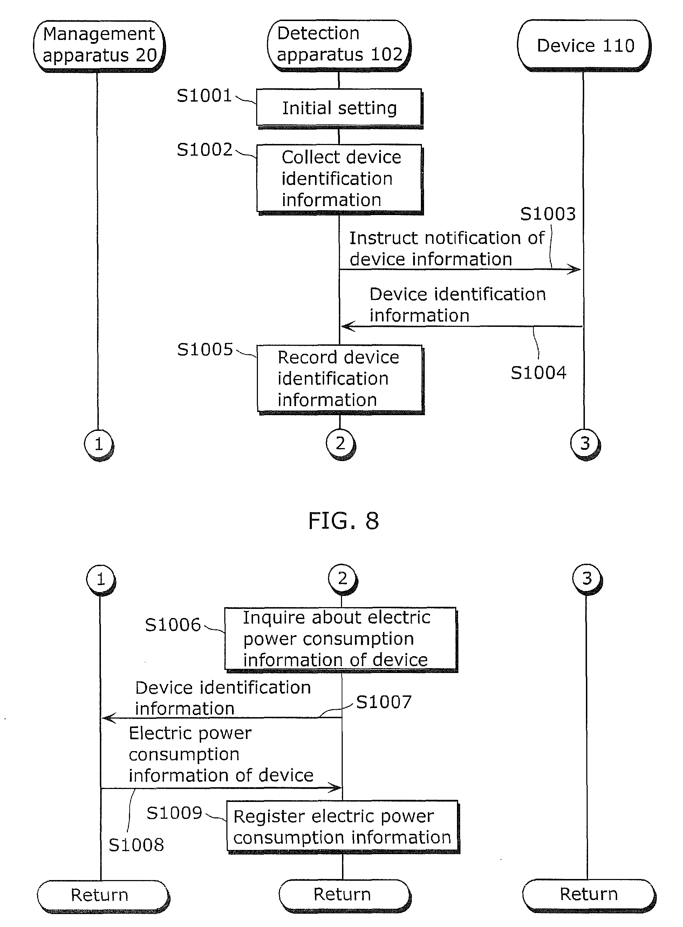

FIGS. 7 and 8 are sequence diagrams for describing the initial registration process of the detection system according to Embodiment 1 of the present invention. In the sequence diagrams shown in FIGS. 7 and 8, only the device 110 is illustrated as a representative of the devices 110 to 113. Operations of the other devices 111 to 113 are basically the same, and thus descriptions of the devices are omitted.

First, the detection apparatus 102 is placed in the residence 10, and performs an initial setting so as to be capable of communicating with the device 110 (S1001). For example, in the initial setting, communication with the devices placed in the residence 10 is set. Here, the communication between the detection apparatus 102 and the device 110 may be performed using a dedicated network line, the Internet, or wireless communication.

Next, the detection apparatus 102 collects information of the device connected in the residence 10 (S1002).

Specifically, the transmission unit 1022 transmits an instruction to notify the detection apparatus 102 of device identification information (S1003) to the device connected in the residence 10.

Then, the device 110 which has received the instruction transmits device identification information (S1004). Here, the device identification information is, for example, information including a type and a model number of the device.

Next, the detection apparatus 102 records the collected device identification information in the device information holding unit 1027 (S1005).

Next, the detection apparatus 102 inquires of the management apparatus 20 about the electric power consumption information of the recorded device 110 (S1006).

Specifically, the transmission unit 1022 transmits the device identification information of the device 110 recorded in the device information holding unit 1027 to the management apparatus 20 (S1007).

Then, the management apparatus 20 transmits electric power consumption information of the device 110 from the received device identification information to the detection apparatus 102 (S1008).

Finally, the detection apparatus 102 receives the electric power consumption information and registers the received electric power consumption information in the device information holding unit 1027 (S1009). Specifically, the update unit 1026 registers the received electric power consumption information in the device information list 10271 or the device information list 10272 held by the device information holding unit 1027 (S1009).

As described above, the detection system performs the initial registration process.

### 6. Operation of detection process

Next, details of the detection process (S200) are described.

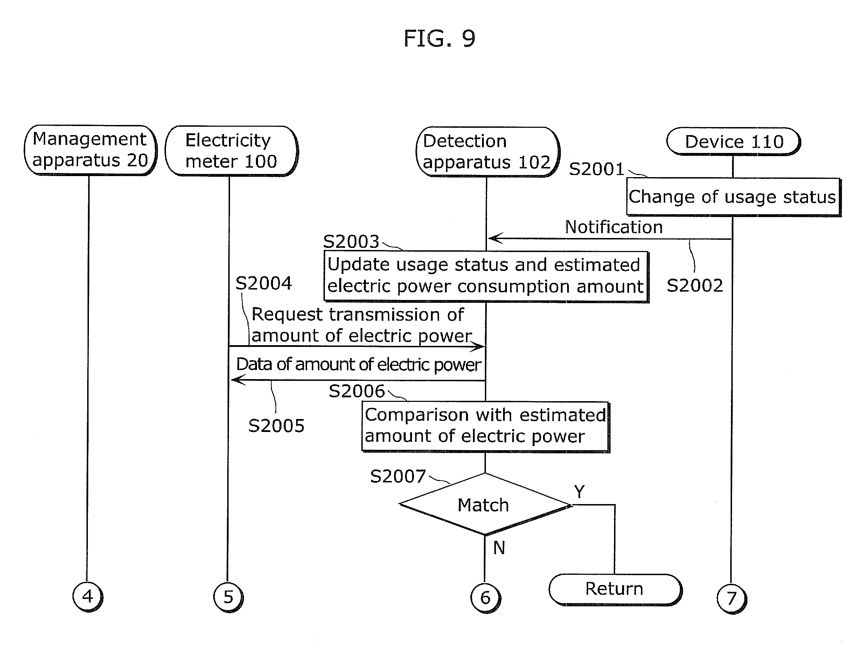

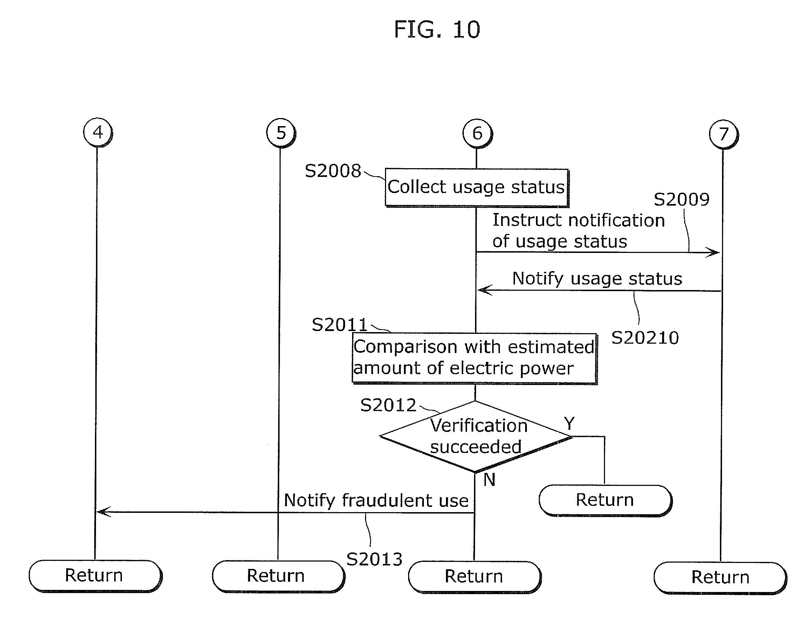

FIGS. 9 and 10 are sequence diagrams for describing the detection process of the detection system according to Embodiment 1 of the present invention. In the sequence diagrams shown in FIGS. 9 and 10, only the device 110 is shown as a representative of the devices 110 to 113 as in FIGS. 7 and 8. Operations of the other devices 111 to 113 are basically the same, and thus descriptions of the devices are omitted.

First, if the usage status of the device 110 is changed (S2001), the device 110 notifies the detection apparatus 102 of the change of the usage status (S2002). Here, the change of the usage status includes situations such as turning on the power of the device, turning off the power of the device, and unplugging the device.

Next, the detection apparatus 102 receives the notification of change in the usage status from the device 110, updates the usage status of the device 110 in the device information list 10271 held in the device information holding unit 1027, and updates the estimated electric power consumption amount which is estimated from the usage status of the device 110 (S2003).

Next, the detection apparatus 102 requests transmission of the currently-used amount of electric power from the electricity meter 100 (S2004).

Next, the electricity meter 100 receives the transmission request for the electric power consumption amount from the detection apparatus 102, and transmits the currently-used amount of electric power to the detection apparatus 102 (S2005).

Next, the detection apparatus 102 compares the received amount of electric power and the estimated electric power consumption amount (S2006).

As a result of the comparison, when the values match (Y in S2007), the detection apparatus 102 determines that the electricity meter 100 is not tampered, and finishes the detection process. Here, the amounts are considered to be matched when the difference between the estimated electric power consumption amount and the amount of electric power received by the reception unit 1021 is less than a predetermined threshold, that is, when the difference between the estimated electric power consumption and the electric power consumption amount of the electricity meter 100 is within a predetermined range. The predetermined range is, for example, a range of difference estimated from an increase in the electric power consumption amount due to an error in the specification, aged deterioration, or usage environment.

On the other hand, when the amounts do not match (N in S2007), usage status of other devices are collected (S2008). This is an operation for checking whether or not the electricity meter 100 is tampered. With this operation, it is possible to determine whether the usage status of other devices is changed, or the other devices are broken.

Specifically, the detection apparatus 102 instructs all devices (here, device 110) to notify of the usage status (S2009). Then, all devices (here, device 110) notify the detection apparatus 102 of the usage status (S2010).

Next, the detection apparatus 102 receives the usage status of all of the devices, and again, compares the estimated electric power consumption amount and the amount of electric power received from the electricity meter 100 (S2011).

As a result of the comparison, when the comparison matches (Y in S2012), the detection apparatus 102 determines that the electricity meter 100 is not tampered, and finishes the detection process. On the other hand, if the comparison does not match (N in S2012) as a result of the comparison, the detection apparatus 102 determines that the electricity meter 100 is tampered, and notifies the management apparatus 20 of the fact (S2013). Note that, as described above, the detection apparatus 102 may notify the management apparatus 20 as well as a user of the fact when the detection apparatus 102 determines that the electricity meter 100 is tampered.

As described above, the detection system performs the initial registration process.

Accordingly, the detection apparatus and the detection system according to this embodiment allow determination of whether or not the electricity meter is tampered by calculating an estimated electric power consumption amount which is estimated from the usage status of devices, comparing the estimated electric power consumption amount and the amount of electric power received from the electricity meter, and verifying the difference. This makes it possible to achieve the detection apparatus and the detection system which detect fraudulent use of the electric power, thereby allowing prevention of the fraudulent use of the electric power due to tampering of the electricity meter.

In addition, the detection apparatus and the detection system according to this embodiment detect tampering of the electricity meter according to a change in usage status of a device. This allows verification of a difference according to the electric power consumption after the usage status of the device is changed, thereby improving the accuracy of detecting tampering of the electricity meter.

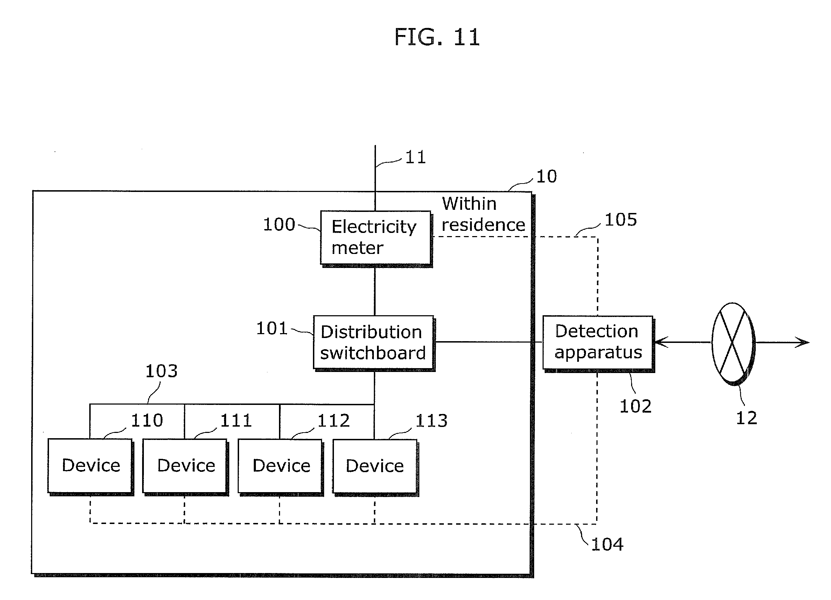

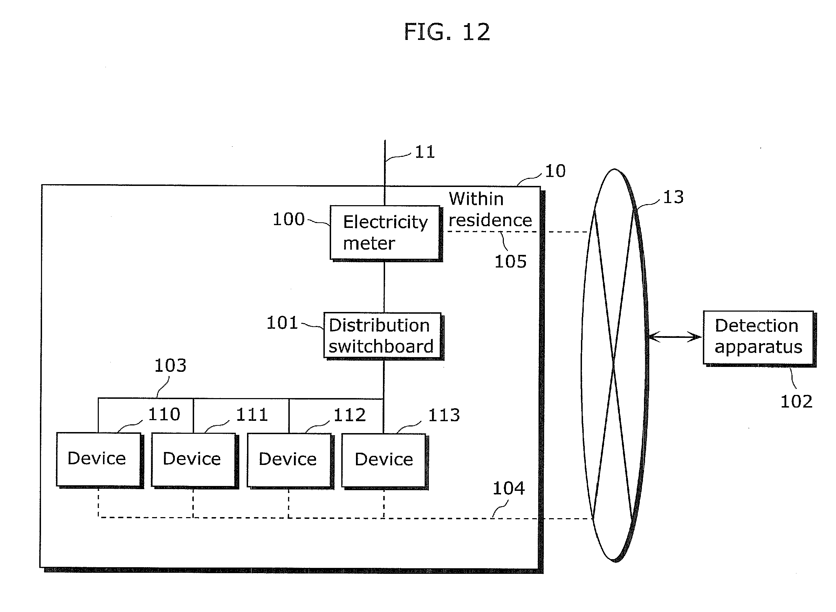

Note that in the above description, the detection apparatus 102 is included in the residence 10, but the present invention is not limited to this configuration. As shown in FIG. 11, the detection apparatus 102 may be placed outside the residence 10. In addition, as shown in FIG. 12, the detection apparatus 102 may be placed outside the residence 10, and may be connected to the devices 110 to 113 in the residence 10 via the network 12. In any case, the above-mentioned effects can be achieved. Note that FIGS. 11 and 12 are diagrams showing different configurations of the residence 10 according to Embodiment 1 of the present invention.

### (Embodiment 2)

Embodiment 2 describes the management apparatus which further verifies whether or not the device information held in the detection apparatus is tampered.

When the device information held in the detection apparatus is tampered, although the electricity meter 100 is tampered, there may be no difference between the amount of electric power indicated by the electricity meter 100 and the estimated electric power consumption amount. Therefore, in this embodiment, the device information is checked to confirm that the device information is not tampered so as to ensure that a difference is obtained between the amount of electric power transmitted from the electricity meter 100 and the estimated electric power consumption amount when the electricity meter 100 is tampered. Thus, the tampering of the electricity meter 100 can surely be detected.

The following describes configurations of a detection apparatus 402 and a management apparatus 40 according to this embodiment.

### 7. Detailed configuration of detection apparatus 402

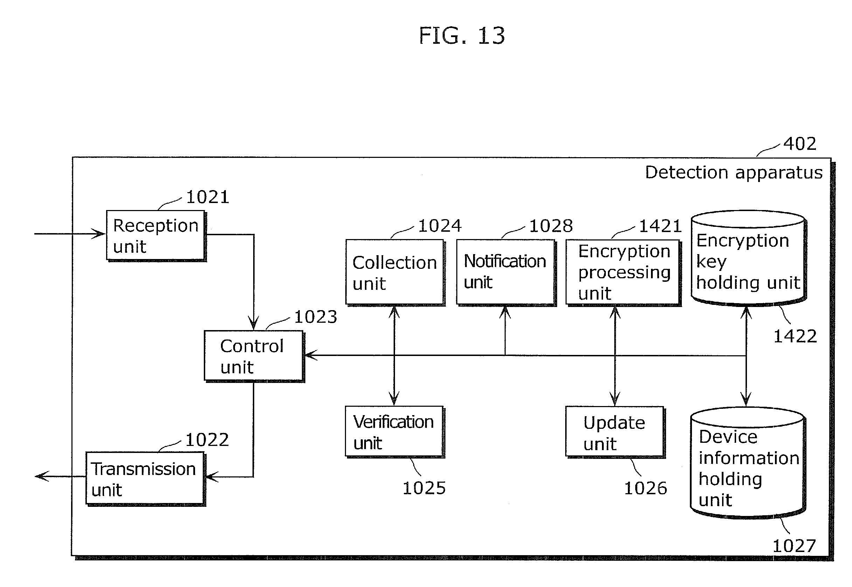

FIG. 13 is a block diagram showing the detailed configuration of the detection apparatus 402 according to Embodiment 2 of the present invention. Elements same as in FIG. 3 are designated by the same reference numerals, and their detailed descriptions are omitted.

The detection apparatus 402 shown in FIG. 13 further includes an encryption processing unit 1421 and an encryption key holding unit 1422 in addition to the elements of the detection apparatus 102 shown in FIG. 3.

The encryption processing unit 1421 encrypts a signature in challenge data and the device information list 10271 (or the device information list 10272).

The encryption key holding unit 1422 holds the encryption key for encrypting the device information list 10271 and a pair of authentication keys (authentication secret key and authentication public key) used for authentication with the management apparatus 40. A certificate issued by the management apparatus 40 is attached to the authentication public key.

Note that a method of signature is described in detail on pages 171 to 187 of NPL 1, and an authentication method based on a technique using the public key is described in detail on pages 155 to 156 of NPL 1, and thus their descriptions are omitted.

The detection apparatus 402 is configured as described above.

### 8. Configuration of management apparatus 40

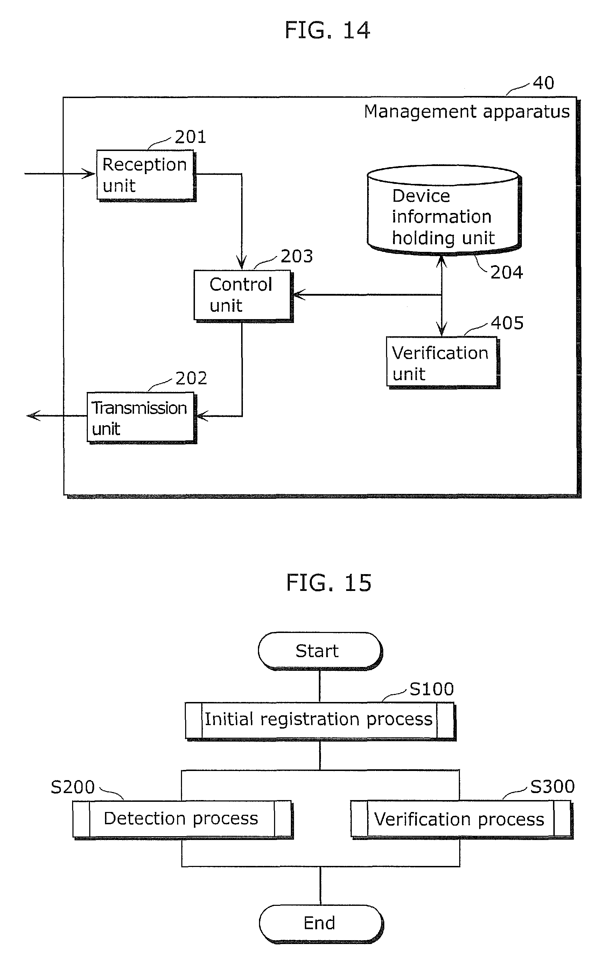

FIG. 14 is a block diagram showing a detailed configuration of the management apparatus 40 according to Embodiment 2 of the present invention. Elements same as in FIG. 5 are designated by the same reference numerals, and their detailed descriptions are omitted.

The management apparatus 40 shown in FIG. 14 includes a verification unit 405 in addition to the management apparatus 20 shown in FIG. 5.

The verification unit 405 verifies whether or not the detection apparatus 402 is tampered. Specifically, the verification unit 405 generates challenge data to be transmitted to the detection apparatus 402, and verifies response data from the detection apparatus 402.

The management apparatus 40 is configured as described above.

Next, a description is given of a detection system including the devices 110 to 113, the detection apparatus 402, and the management apparatus 40. A configuration of each of the elements of the detection system is omitted because it has been already described above. The following describes an operation of the detection system.

### 9. Summary of operation of detection system

FIG. 15 is a flowchart for describing a general process of the detection system according to Embodiment 2 of the present invention. Elements same as in FIG. 6 are designated by the same reference numerals, and their detailed descriptions are omitted.

The detection system according to Embodiment 2 performs a verification process (S300) in addition to the processes of the detection system according to Embodiment 1.

Specifically, in the verification process (S300), it is verified whether or not the device information list 10271 (or the device information list 10272) held in the detection apparatus 402 is tampered, an authentication process with the management apparatus 40 is performed, and a verification result is transmitted.

### 10. Operation of verification process

Next, details of the verification process (S300) according to Embodiment 2 are described.

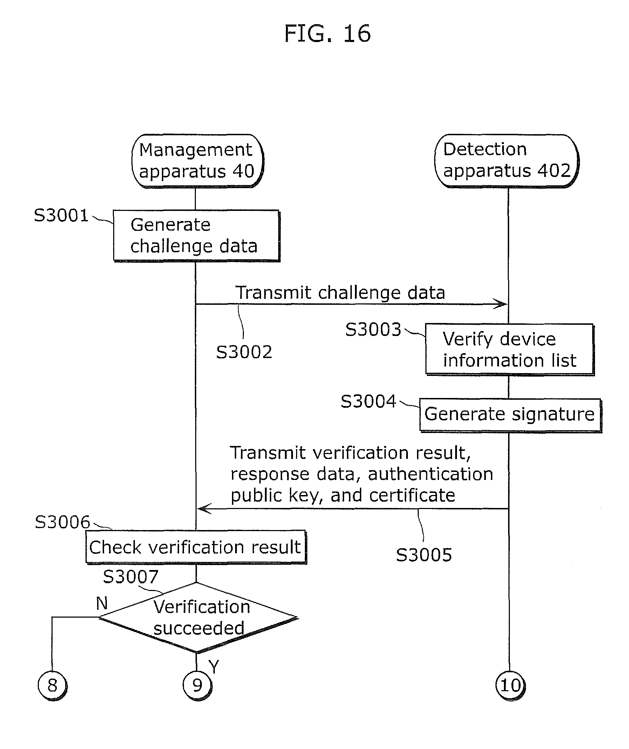

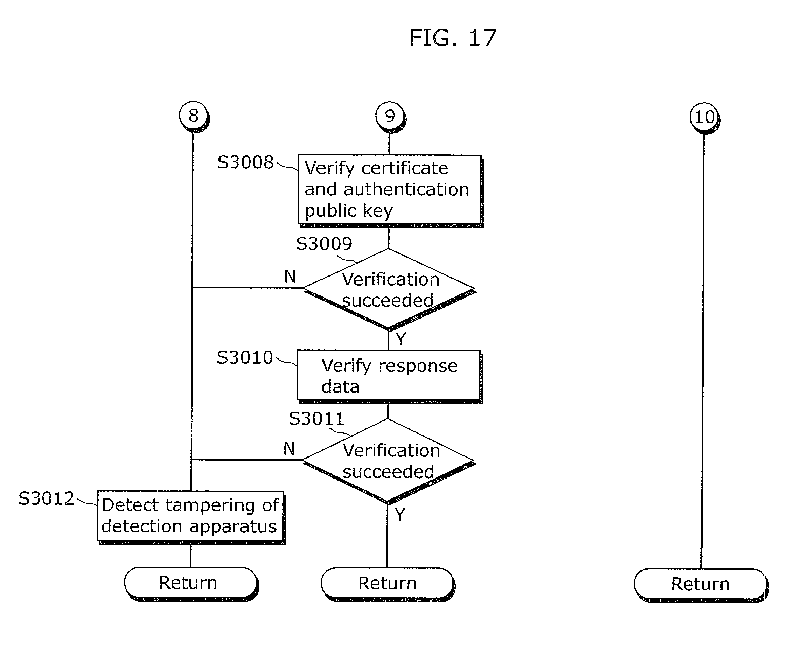

FIGS. 16 and 17 are sequence diagrams for describing the verification process of the detection system according to Embodiment 2 of the present invention.

In the verification process (S300), the management apparatus 40 authenticates the detection apparatus 402, and checks whether or not the device information (the device information list 10271 or device information list 10272) is tampered. Hereinafter, a description is given by considering the device information is the device information list 10271.

Specifically, first, the management apparatus 40 generates a random number and the random number is used as challenge data (S3001). Subsequently, the challenge data is transmitted to the detection apparatus 402 (S3002).

Next, the detection apparatus 402 receives the challenge data. Subsequently, it is verified whether or not the device information list 10271 held in the device information holding unit 1027 is tampered (S3003). Note that there are various methods for the verification of the device information list 10271. For example, there is a method in which a hash value of the device information list 10271 is recorded at the initial registration process. Then, it is checked whether or not the recorded hash value and the calculated hash value match. Another example is a method in which the device information list 10271 and a given value are encrypted and recorded, and whether or not the given value matches the device information list is checked.

Next, the detection apparatus 402 generates a signature by using an authentication secret key and uses the generated signature as response data (S3004).

Next, the detection apparatus 402 transmits the verification result, the response data, an authentication public key, and a certificate of the verification key to the management apparatus 40 (S3005).

Next, the management apparatus 40 receives the verification result, the response data, the authentication public key, and the certificate of the verification key from the detection apparatus 402, and firstly checks whether or not the verification result is correct (S3006).

Then, when the verification performed by the detection apparatus 402 is succeeded (Y in S3007), the management apparatus 40 verifies whether or not the certificate of the authentication key is the certificate issued by the management apparatus 40, and verifies the authentication public key using the certificate of the authentication key (S3008).

Next, when the verification is succeeded (Y in S3009) as a result of the verification, the management apparatus 40 verifies the signature using the authentication public key whether or not the received response data is the signature of the challenge data (S3010). When the verification is succeeded (Y in S3011) as a result of the verification, the management apparatus 40 determines that the device information list 10271 of the detection apparatus 402 is not tampered, and the verification process is ended.

Note that the detection apparatus 402 is determined to be fraudulently tampered (S3012) in the cases where the device information list 10271 of the detection apparatus 402 is not verified in the verification (N in S3007), where there is a problem in the authentication key certificate and the authentication public key (N in S3009), or where the response data is incorrect (N in S3011).

Accordingly, when the detection apparatus 402 is tampered, the tampering can be more accurately detected by verifying the device information held by the detection apparatus 402 and performing the authentication process. This enables detection of the tampering even when the detection apparatus 402 is tampered so that there would not be a difference between the estimated electric power consumption amount which is calculated (estimated) from the device information list 10271 and the amount of electric power indicated by the electricity meter 100. In other words, tampering of the detection apparatus 402 can be prevented according to this embodiment, and thus the tampering of the electricity meter can surely be detected.

As described above, the detection apparatus and the detection system which detect fraudulent use of the electric power can be achieved according to the present invention.

### (Other modifications)

The present invention has been described according to above-mentioned embodiments, it would be understood that the present invention is not limited to the above-mentioned embodiments. The present invention also includes the followings.

(1) In the above embodiments, four devices, devices 110 to 113, are used as the devices but the present invention is not limited to this. A plurality of devices may be used.

(2) In the above-mentioned embodiments, the management apparatus has the device information holding unit, but the present invention is not limited to this. There may be a plurality of management apparatuses holding device information. In this case, the detection apparatus may select a management apparatus for inquiring about the device identification information depending on a device being inquired, or may inquire of all of the management apparatuses.

(3) In the above embodiments, in S1006, the detection apparatus inquires of the management apparatus about the electric power consumption information included in the device information, but the present invention is not limited to this. The detection apparatus may receive the electric power consumption information from the devices. In this case, the electric power consumption information may be added to the transmission of the device identification information in S1004. In addition, a digital signature of the management apparatus 20 may be added to the device identification information.

(4) In the above embodiments, in S1004, the devices transmit the device identification information to the detection apparatus, but the present invention is not limited to this. The user of the devices may register the device identification information in the detection apparatus. Here, the registration method of the device identification information may include a method of registering the device identification information via a recording medium, and a method of directly inputting the device identification information to the detection apparatus.

(5) In the above-mentioned embodiments, the detection apparatus compares the received amount of electric power with the estimated electric power consumption amount as an operation of the detecting process when the usage status of the devices are changed, but the present invention is not limited to this. The detection apparatus may receive the electric power consumption amount from the electricity meter 100 periodically or non-periodically, and compare the received amount of electric power with the estimated electric power consumption amount. By doing so, whether or not the electricity meter 100 is tampered can be determined even if a device which is broken or tampered does not notify the usage status. Therefore, the tampering of the electricity meter 100 can surely be detected.

(6) In the above embodiments, the management apparatus receives notification from the detection apparatus when the electricity meter 100 is tampered, the management apparatus may further notify a power company of the occurrence of the fraudulent use when the management apparatus receives the notification.

(7) In the above embodiments, in S1009, the detection apparatus registers the electric power consumption information of the device received from the management apparatus and calculates an estimated electric power consumption amount estimated from the registered electric power consumption information, but the present invention is not limited to this. As described above, the registered electric power consumption information may be updated based on the history of the usage status of the device. At this time, the collection unit 1024 of the detection apparatus collects the usage status of the device and the usage history information as in the above embodiments, but the present invention is not limited to this. The detection apparatus may further include a history information holding unit which holds usage history information. Here, an example of the updating method of the update unit 1026 is taking an average between the electric power consumption registered for the device and the electric power consumption of the device in use. Another example of the method is calculating the average of all the previous electric power consumption in use and then updating the electric power consumption information. Moreover, when a device whose electric power consumption varies due to time or settings being used, for example, a device such as an air conditioner whose driving status changes between air-cooling and heating, and a device such as a vacuum cleaner whose power consumption in use varies depending on a load, the average electric power consumption in each driving status may be calculated and electric power consumption for each driving status may be registered.

(8) In the above embodiments, in S1009, the detection apparatus registers the electric power consumption information of the device received from the management apparatus, and calculates an estimated the electric power consumption amount estimated from the registered electric power consumption information, but the present invention is not limited to this. The detection apparatus may predict an electric power consumption amount estimated from setting status of a device and information on the environment for using the device, and update the registered electric power consumption information. Here, the setting status of the device is, for example, a temperature setting or humidity of the air conditioner, and setting of the strength of the suction of the vacuum clearer. In addition, the information on the environment in which the device is used includes a temperature and humidity of a room, and a degree of uncleanness of the air and a floor. This is because, for example, the load of the air conditioner may vary depending on the temperature and the humidity of the room, and the load of the vacuum cleaner may vary depending on the uncleanness of the air and the floor. In other words, the load varies and the electric power consumption amount changes depending on the information of the environment in which the devices are used.

(9) In the above embodiments, the device information is registered in the initial registration process but the present invention is not limited to this. The device information may be registered in a different occasion other than the initial registration process. Hereinafter, a process of adding the device information is described with reference to an example of adding the device 114.

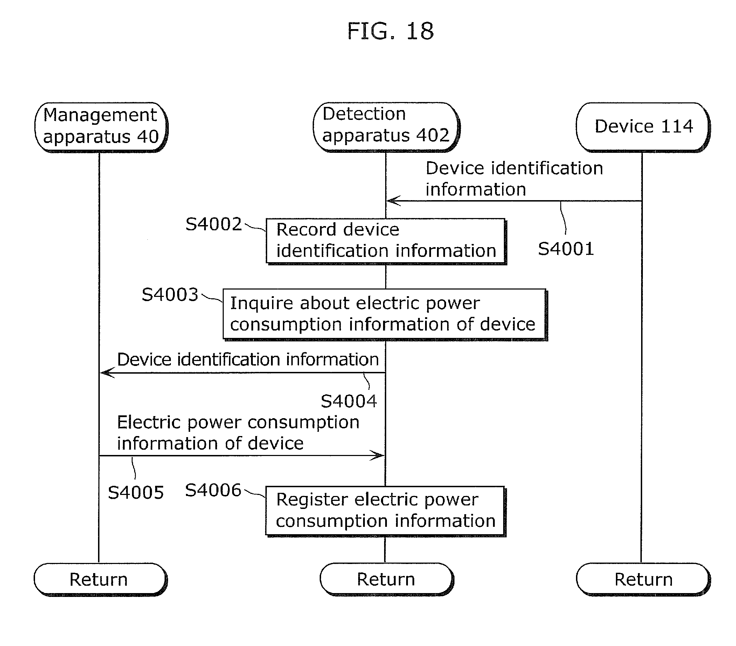

FIG. 18 is a sequence diagram for explaining a process of adding the device information in the modification of Embodiment 2 of the present invention.

In the process of adding the device information, first, the device 114 transmits the device identification information to the detection apparatus 402 (S4001). Next, the detection apparatus 402 records the device identification information of the device 114 in the device information list 10271 of the device information holding unit 1027 (S4002). Next, the detection apparatus 402 inquires of the management apparatus 40 about the electric power consumption information such as electric power consumption or standby electric power of the device 114 (S4003). Next, the detection apparatus 402 transmits the device identification information of the device 114 to the management apparatus 40 (S4004). Next, the management apparatus 40 transmits electric power consumption information of the standby electric power and the electric power consumption from the received device identification information to the detection apparatus 402 (S4005). Next, the detection apparatus 402 receives the electric power consumption information of the device 114, and the update unit 1026 registers the standby electric power and the electric power consumption of the device 114 in the device information list 10271 (or the device information list 10272) held by the device information holding unit 1027 (S4006).

Note that the detection apparatus 402 and the management apparatus 40 in Embodiment 2 are described, but the present invention is not limited to the above. The same may be applied to the detection apparatus 102 and the management apparatus 20 in Embodiment 1.

(10) Moreover, in the modification described in the above-mentioned (9), the process of adding device information is performed by transmitting the device identification information by the device, but the present invention is not limited to this. The detection apparatus may determine existence of an unregistered device periodically or non-periodically, and add the device information. An example of the method of determining whether there is an unregistered device is a method in which the detection apparatus transmits an instruction of transmitting the device identification information to all of the devices in the residence 10, and determines if there is an unregistered device using the received device identification information. Moreover, another example is a method of determining whether a device is registered in the device information list 10271 (the device information list 10272) when a notification of change of the usage status is received from the device in the detection process.

(11) In the above embodiments, the detection apparatus performs comparison with the estimated electric power consumption amount when the usage status of a device is changed, but the present invention is not limited to this. The comparison with the estimated electric power consumption amount may be performed by transmitting a command of changing usage status of a device from the detection apparatus and changing the usage status of the device. Moreover, the timing of transmitting the command from the detection apparatus may be a time when the usage status of devices would not change by considering the time when the devices are not used so often. For example, a time when there is no change in the usage status of devices is learned from the usage status of each device for a residence where devices are not used in the middle of the night or a residence where devices are not used during day. With this, a command of changing the usage status is transmitted to change the usage status, and the detection is performed without being affected by the other devices.

(12) In the above embodiments, the detection apparatus performs comparison with the estimated electric consumption amount as an operation of the detection process when usage status of a device is changed, but the present invention is not limited to this. The detection apparatus may perform comparison with the estimated electric power consumption amount only when the usage status of the device having stable electric power consumption is changed. For example, comparison with the estimated electric power consumption is performed only when usage status of a target device is changed by receiving a list of devices having stable electric power consumption from the management apparatus, and setting a flag to a device having stable electric power consumption in the device information list 10271 (device information list 10272) according to the received list. With this, tampering in a device having stable electric power consumption can be detected with high accuracy when a difference is obtained between the estimated electric power consumption amount and the electric power consumption amount.

(13) In the above embodiments, stealing electric power or fraudulent use of the electric power is prevented by detecting tampering of the electricity meter, but the detection of tampering of the electricity meter in the above embodiments may also be used in the case where electric power generated in the residence is sold (selling electric power) to the power company.

(14) In the above embodiments, tampering of the electricity meter is detected, but the present invention is not limited to this. Breakdown of the electricity meter may also be detected.

(15) In the above embodiments, the detection apparatus detects tampering of the electricity meter 100 by performing comparison with the estimated electric power consumption amount and verifying the difference as an operation of the detection process, but the present invention is not limited to this. The detection apparatus may detect tampering or breakdown of a device. For example, in the operation of the detection process, devices notify of the change of the usage status, but a device may be determined to be tampered or broken when the electric power consumption amount is unchanged even when the device has notified of the change of the usage status. Moreover, devices may be determined to be tampered or broken when the electric power consumption amount is changed according to the usage status but the electric power consumption amount is increased more than the estimated range, for example, due to increase of the electric power consumption amount because of a difference between the actual electric consumption amount and the amount in the specification and increase in the electric power consumption amount due to the usage environment.

(16) Each module described above may be, for example, an individual computer program, a module incorporated in an operating system, a driver called from the operating system, or an application program.

(17) Each device described above is specifically a computer system including a microprocessor, ROM, RAM, a hard disk unit, a display unit, a keyboard, a mouse, and so on. The RAM or the hard disk unit has a computer program recorded thereon. The microprocessor performs an operation according to the computer program, and thereby each device achieves its function. Here, the computer program is configured by combining a plurality of instruction codes each indicating a command for a computer to achieve a predetermined function.

(18) A part of or whole elements included in each device described above may be in a system large scale integration (LSI). The system LSI is a super-multifunction LSI manufactured by integrating a plurality of parts in one chip. Specifically, the system LSI is a computer system including a microprocessor, ROM, RAM, and so on. The RAM has a computer program recorded thereon. The microprocessor operates according to the computer program, and thereby the system LSI achieves its function.

Moreover, each unit of the element structuring each device described above may be integrated into a separate single chip, or some or all of the functional blocks may be integrated into a single chip. Although the integrated circuit is here referred to as an LSI, it may be referred to as an IC, a system LSI, a super LSI or an ultra LSI, depending on the degree of integration. The method of forming integrated circuitry is not limited to use of LSIs. Dedicated circuitry or a general-purpose processor may be used instead of LSIs. Also applicable is a field programmable gate array (FPGA), which allows post-manufacture programming, or a reconfigurable processor LSI, which allows post-manufacture reconfiguration of connection and setting of circuit cells therein. Furthermore, in the event that an advance in or derivation from semiconductor technology brings about an integrated circuitry technology whereby an LSI is replaced, the functional blocks may be obviously integrated using such new technology. The adaptation of biotechnology or the like is possible.

(19) It is possible that a part or all of the constituent elements making up each of the above-mentioned devices is made from an IC card that can be attached to/detached from each device, or a stand-alone module. The IC card or the module is a computer system made from a microprocessor, a ROM, a RAM, and so on. The IC card or the module may include the super multi-function LSI. The IC card or the module accomplishes its functions through the operation of the microprocessor in accordance with the computer program. The IC card or the module may also be tamper-resistant.

(20) The present invention may also be the methods described thus far. In addition, the invention may be a computer program which achieves these methods by a computer, or may be a digital signal including the computer program. In addition, the present invention may be a computer-readable recording medium such as a flexible disk, a hard disk, a CD-ROM, an MO, a DVD, a DVD-ROM, a DVD-RAM, a BD (Blu-ray Disc), a semiconductor memory, on which the computer program or the digital signal is recorded. In addition, the present invention may be the digital signal recorded in one of these recording media. Furthermore, according to the present invention, the computer program or the digital signal may be transmitted via a telecommunications line, a wired or wireless communication line, a network typified by the Internet, or data broadcasting.

In addition, the present invention may be a computer system including a microprocessor and a memory where the above-mentioned computer program is recorded in the memory, and the microprocessor operates in accordance with the computer program. In addition, the program or the digital signal may be recorded in the recording medium and transferred, or the program or the digital signal may be transferred via the network so as to be executed by an another independent computer system.

(21) The above-described embodiments and modifications may be combined in an arbitrary manner.

### [Industrial Applicability]

The present invention may be used in detection apparatuses and detection systems. In particular, the present invention may be used in a detection apparatus and a detection system which are widely used in an information processing device which obtains verification data for verifying software from an external server connected via a network, and verifies the software within the information processing device itself by using the obtained verification data.

### [Reference Signs List]

- 10: Residence
- 11: Leading wire
- 12: Network
- 20, 40: Management apparatus
- 30: Substation
- 31: Power line
- 100: Electricity meter
- 101: Distribution switchboard
- 102, 402: Detection apparatus
- 110, 111, 112, 113, 114: Device
- 201, 1021: Reception unit
- 202, 1022: Transmission unit
- 203, 1023: Control unit
- 204, 1027: Device information holding unit
- 405: Verification unit
- 1024: Collection unit
- 1025: Determination unit
- 1026: Update unit
- 1028: Notification unit
- 1421: Encryption processing unit
- 1422: Encryption key holding unit
- 10271, 10272: Device information list

## Claims

1. A detection apparatus connected to a device in a residence and an electricity meter indicating an amount of electric power consumed by the device in the residence, said detection apparatus comprising:
a reception unit configured to receive the amount of electric power from the electricity meter;
a collection unit configured to collect usage status of the device;
a device information holding unit configured to hold device information including the usage status of the device and electric power consumption of the device corresponding to the usage status; and
a determination unit configured to determine whether or not the electricity meter is tampered, by comparing an estimated electric power consumption amount with the amount of electric power received by said reception unit, the estimated electric power consumption amount being estimated from the usage status of the device by using the device information,
wherein said determination unit is configured to determine that the electricity meter is tampered, when a difference between the estimated electric power consumption amount and the amount of electric power received by said reception unit is equal to or more than a predetermined threshold.

2. The detection apparatus according to Claim 1,
wherein said reception unit is configured to receive, from the electricity meter, an amount of electric power when the usage status of the device is changed, and
said determination unit is configured to determine whether or not the electricity meter is tampered, by comparing an estimated electric power consumption amount with the amount of electric power received by said reception unit, the estimated electric power consumption amount being estimated from the changed usage status of the device by using the device information.

3. The detection apparatus according to Claim 1, further comprising
a notification unit configured to notify a user of information indicating that the electricity meter is determined to be tampered, when said determination unit determines that the electricity meter is tampered.

4. The detection apparatus according to Claim 1, further comprising
an update unit configured to update the device information,
wherein said collection unit is further configured to collect usage history information including previous electric power consumption amounts for usage status of the device, and
said update unit is configured to update the device information by reflecting the usage history information in the usage status of the device and the electric power consumption of the device corresponding to the usage status.

5. The detection apparatus according to Claim 1, further comprising
an update unit configured to update the device information,
wherein said collection unit is further configured to collect device setting information indicating a load of the device in use and a setting of the device in use, and
said update unit is configured to update the device information by reflecting the device setting information in the usage status of the device and the electric power consumption of the device corresponding to the usage status.

6. The detection apparatus according to any one of Claims 1 to 5,
wherein the usage status includes at least a state where a power of the device is ON and a state where the power of the device is OFF.

7. The detection apparatus according to Claim 1, further comprising
a device information verification unit configured to verify whether or not the device information held by said device information holding unit is tampered.

8. A detection system, comprising:
a device in a residence;
an electricity meter indicating an amount of electric power consumed by the device in the residence; and
a detection apparatus connected to the electricity meter and the device in the residence,
wherein said detection apparatus includes:
a reception unit configured to receive the amount of electric power from the electricity meter;
a collection unit configured to collect usage status of the device;
a device information holding unit configured to hold device information including the usage status of the device and electric power consumption of the device corresponding to the usage status; and
a determination unit configured to determine whether or not the electricity meter is tampered, by comparing an estimated electric power consumption amount with the amount of electric power received by said reception unit, the estimated electric power consumption amount being estimated from the usage status of the device by using the device information,
wherein said determination unit is configured to determine that the electricity meter is tampered, when a difference between the estimated electric power consumption amount and the amount of electric power received by said reception unit is equal to or more than a predetermined threshold.

9. The detection system according to Claim 8, further comprising
a management apparatus connected to said detection apparatus,
wherein said management apparatus includes a verification unit configured to verify whether or not said detection apparatus is tampered.

10. The detection system according to Claim 8 or 9,
wherein said detection apparatus is placed outside the residence.

11. A detection method used for a detection apparatus connected to a device in a residence and an electricity meter consumed by the device in the residence, said method comprising:
receiving an amount of electric power from the electricity meter;
holding device information including usage status of the device and electric power consumption of the device corresponding to the usage status; and
determining whether or not the electricity meter is tampered, by comparing an estimated electric power consumption amount with the amount of electric power received by the reception unit, the estimated electric power consumption amount being estimated from the usage status of the device by using the device information,
wherein in said determining, the electricity meter is determined to be tampered, when a difference between the estimated electric power consumption amount and the amount of electric power received by the reception unit is equal to or more than a predetermined threshold.

12. A detection program used for a detection apparatus connected to a device in a residence and an electricity meter consumed by the device in the residence, said program comprising:
receiving an amount of electric power from the electricity meter;
holding device information including usage status of the device and electric power consumption of the device corresponding to the usage status; and
determining whether or not the electricity meter is tampered, by comparing an estimated electric power consumption amount with the amount of electric power received by the reception unit, the estimated electric power consumption amount being estimated from the usage status of the device by using the device information,
wherein in said determining, the electricity meter is determined to be tampered, when a difference between the estimated electric power consumption amount and the amount of electric power received by the reception unit is equal to or more than a predetermined threshold.

13. An integrated circuit connected to a device in a residence and an electricity meter indicating an amount of electric power consumed by the device in the residence, said detection apparatus comprising:
a reception unit configured to receive the amount of electric power from the electricity meter;
a collection unit configured to collect usage status of the device;
a device information holding unit configured to hold device information including the usage status of the device and electric power consumption of the device corresponding to the usage status; and
a determination unit configured to determine whether or not the electricity meter is tampered, by comparing an estimated electric power consumption amount with the amount of electric power received by said reception unit, the estimated electric power consumption amount being estimated from the usage status of the device by using the device information,
wherein said determination unit is configured to determine that the electricity meter is tampered, when a difference between the estimated electric power consumption amount and the amount of electric power received by said reception unit is equal to or more than a predetermined threshold.

## Amended claims

### Amended claims under Art. 19.1 PCT

**1.** A detection apparatus connected to a device in a residence and an electricity meter indicating an amount of electric power consumed by the device in the residence, said detection apparatus comprising:
a reception unit configured to receive the amount of electric power from the electricity meter;
a collection unit configured to collect usage status of the device;
a device information holding unit configured to hold device information including the usage status of the device and electric power consumption of the device corresponding to the usage status; and
a determination unit configured to determine whether or not the electricity meter is tampered, by comparing an estimated electric power consumption amount with the amount of electric power received by said reception unit, the estimated electric power consumption amount being estimated from the usage status of the device by using the device information,
wherein said determination unit is configured to determine that the electricity meter is tampered, when a difference between the estimated electric power consumption amount and the amount of electric power received by said reception unit is equal to or more than a predetermined threshold.

**2.** The detection apparatus according to Claim 1,
wherein said reception unit is configured to receive, from the electricity meter, an amount of electric power when the usage status of the device is changed, and
said determination unit is configured to determine whether or not the electricity meter is tampered, by comparing an estimated electric power consumption amount with the amount of electric power received by said reception unit, the estimated electric power consumption amount being estimated from the changed usage status of the device by using the device information.

**3.** The detection apparatus according to Claim 1, further com prising
a notification unit configured to notify a user of information indicating that the electricity meter is determined to be tampered, when said determination unit determines that the electricity meter is tam pered.

**4.** The detection apparatus according to Claim 1, further com prising
an update unit configured to update the device information,
wherein said collection unit is further configured to collect usage history information including previous electric power consumption amounts for usage status of the device, and
said update unit is configured to update the device information by reflecting the usage history information in the usage status of the device and the electric power consumption of the device corresponding to the usage status.

**5.** The detection apparatus according to Claim 1, further com prising
an update unit configured to update the device information,
wherein said collection unit is further configured to collect device setting information indicating a load of the device in use and a setting of the device in use, and
said update unit is configured to update the device information by reflecting the device setting information in the usage status of the device and the electric power consumption of the device corresponding to the usage status.

**6.** The detection apparatus according to any one of Claims 1 to 5,
wherein the usage status includes at least a state where a power of the device is ON and a state where the power of the device is OFF

**7.** The detection apparatus according to Claim 1, further com prising
a device information verification unit configured to verify whether or not the device information held by said device information holding unit is tampered.

**8.** A detection system, comprising:
a device in a residence;
an electricity meter indicating an amount of electric power consumed by the device in the residence; and
a detection apparatus connected to the electricity meter and the device in the residence,
wherein said detection apparatus includes:
a reception unit configured to receive the amount of electric power from the electricity meter;
a collection unit configured to collect usage status of the device;
a device information holding unit configured to hold device information including the usage status of the device and electric power consumption of the device corresponding to the usage status; and
a determination unit configured to determine whether or not the electricity meter is tampered, by comparing an estimated electric power consumption amount with the amount of electric power received by said reception unit, the estimated electric power consumption amount being estimated from the usage status of the device by using the device information,
wherein said determination unit is configured to determine that the electricity meter is tampered, when a difference between the estimated electric power consumption amount and the amount of electric power received by said reception unit is equal to or more than a predetermined threshold.

**9.** The detection system according to Claim 8, further comprising
a management apparatus connected to said detection apparatus,
wherein said management apparatus includes a verification unit configured to verify whether or not said detection apparatus is tam pered.

**10.** The detection system according to Claim 8 or 9,
wherein said detection apparatus is placed outside the residence.

**11.** A detection method used for a detection apparatus connected to a device in a residence and an electricity meter consumed by the device in the residence, said method comprising:
receiving an amount of electric power from the electricity meter;
holding device information including usage status of the device and electric power consumption of the device corresponding to the usage status; and
determining whether or not the electricity meter is tampered, by comparing an estimated electric power consumption amount with the amount of electric power received by the reception unit, the estimated electric power consumption amount being estimated from the usage status of the device by using the device information,
wherein in said determining, the electricity meter is determined to be tampered, when a difference between the estimated electric power consumption amount and the amount of electric power received by the reception unit is equal to or more than a predetermined threshold.

**12.** A detection program used for a detection apparatus connected to a device in a residence and an electricity meter consumed by the device in the residence, said program comprising:
receiving an amount of electric power from the electricity meter;
holding device information including usage status of the device and electric power consumption of the device corresponding to the usage status; and
determining whether or not the electricity meter is tampered, by comparing an estimated electric power consumption amount with the amount of electric power received by the reception unit, the estimated electric power consumption amount being estimated from the usage status of the device by using the device information,
wherein in said determining, the electricity meter is determined to be tampered, when a difference between the estimated electric power consumption amount and the amount of electric power received by the reception unit is equal to or more than a predetermined threshold.

**13.** An integrated circuit connected to a device in a residence and an electricity meter indicating an amount of electric power consumed by the device in the residence, said integrated circuit com prising:
a reception unit configured to receive the amount of electric power from the electricity meter;
a collection unit configured to collect usage status of the device;
a device information holding unit configured to hold device information including the usage status of the device and electric power consumption of the device corresponding to the usage status; and
a determination unit configured to determine whether or not the electricity meter is tampered, by comparing an estimated electric power consumption amount with the amount of electric power received by said reception unit, the estimated electric power consumption amount being estimated from the usage status of the device by using the device information,
wherein said determination unit is configured to determine that the electricity meter is tampered, when a difference between the estimated electric power consumption amount and the amount of electric power received by said reception unit is equal to or more than a predetermined threshold.
